Europäisches Patentamt

European Patent Office

Office européen des brevets

(11) Publication number: **0 271 466 B1**

(12) **EUROPEAN PATENT SPECIFICATION**

(45) Date of publication of patent specification: **27.04.94**  (51) Int. Cl.⁵: **C23C 18/16**, C23C 18/28

(21) Application number: **87870156.4**

(22) Date of filing: **06.11.87**

(54) **Selective catalytic activation of polymeric films.**

(30) Priority: **07.11.86 US 928499**
**19.06.87 US 64898**

(43) Date of publication of application:
**15.06.88 Bulletin 88/24**

(45) Publication of the grant of the patent:
**27.04.94 Bulletin 94/17**

(84) Designated Contracting States:
**AT BE CH DE ES FR GB GR IT LI LU NL SE**

(56) References cited:
**GB-A- 1 154 152**
**US-A- 3 904 783**

**IBM TECHNICAL DISCLOSURE BULLETIN, vol. 8, no. 9, February 1966, page 1174, NewYork, US; R.S. HAINES: "Metallizing nonconductive substrates"**

(73) Proprietor: **Monsanto Company**
**Patent Department**
**800 North Lindbergh Boulevard**
**St. Louis Missouri 63167-7020(US)**

(72) Inventor: **O'Connor, Michael Terence, Jr.**
**181 Wildwood Avenue**
**Springfield Massachusetts 01118(US)**
Inventor: **Capistran, James Dennis**
**101 Third Street**
**Suffield Connecticut 06078(US)**
Inventor: **Brozek, James Philip**
**138 Longview Circle**
**Ludlow Massachusetts 01056(US)**
Inventor: **Morgan, Albert Wayne**
**5 Hawthorne Road**
**Wilbraham Massachusetts 01095(US)**

(74) Representative: **Ernst, Hubert et al**
**Monsanto Services International S.A.**
**Avenue de Tervuren 270/272**
**B-1150 Brussels (BE)**

EP 0 271 466 B1

**Description**

Disclosed herein are inventions relating to articles with catalytically-activatible surface layers, e.g. activatible by radiant energy to provide articles having a polymeric surface layer with nascent clusters of at least one Group 1B or Group 8 metal; articles comprising such nascent clusters which can be reduced to metal clusters to provide catalytically-active surfaces; articles having such catalytically-active surfaces, e.g. to catalyze electroless deposition; articles having electrolessly-deposited metal surfaces, e.g. oxidation-resistant copper surfaces; solutions for forming such catalytically-activatable surface layers; and methods for preparing and using such articles and solutions.

BACKGROUND OF THE INVENTION

Catalytic surfaces are provided on polymer substrates for a variety of purposes, including to provide initiation for electroless deposition of metal. Electroless deposition as used herein refers to the surface deposition from solution of a reduced metal coating onto a substrate by use of a chemical reducing agent without an outside source of electric current. Electroless deposition is used to deposit such metals as nickel, copper, gold, rhodium and palladium onto non-conductive substrates, e.g. polymeric substrates, to provide printed circuit boards, laser or magnetic data storage devices, catalytic devices, electromagnetic shielding of electronic equipment housings, conductive coatings, decorative coatings, antistatic coatings and the like.

Electroless deposition is generally catalyzed by reduced metal sites on the surface to be coated. Such deposition is often initially catalyzed by reduced palladium compounds distributed over the surface. Once initiated, electroless deposition is autocatalytic in that deposited reduced metal provides an expanding catalytic surface for further deposition.

Considerable effort in the art of electroless deposition has been devoted to improving the quality of electrolessly-deposited metal coatings. U.S. Patent 3,414,427 discloses that better adhesion of metal coatings is achieved by use of a more soluble complex, e.g. of palladium chloride, hydrogen chloride and water. Other developments based on modified palladium complexes are disclosed in U.S. Patents 3,520,723 (cuprous iodide treatment), 3,847,648 (ketopalladium complexes), 3,937,857 and 4,006,047 (thermodecomposable palladium complexes) and 3,963,841 (dimethyl sulfoxide complexes). See also Matijevic et al., "The Characterization of the Stannous Chloride/Palladium Chloride Catalysts for Electroless Plating", Plating and Surface Finishing, page 958 (Oct. 1975), which states that colloidal palladium is necessary for catalytic activity and that solutions of palladium complexes do not act as catalysts.

Other attempts to improve metal coating adhesion have included etching of polymeric substrates, e.g. with chromic and/or sulfuric acid. See, for instance, U.S. Patents 3,370,974; 3,423,226; 3,437,507; 3,507,681; 3,515,649; 3,616,296; and 3,702,286 which disclose various acid etching techniques which are often useful in preparing surfaces comprising ABS (a multiphase thermoplastic of dispersed butadiene with grafted styrene acrylonitrile copolymer). See also U.S. Patents 4,645,573 and 4,645,574 which disclose such acid treatment in the preparation of metal-coated polyester and polyamide filaments, respectively.

Another method of improving adhesion is disclosed in U.S. Patent 3,488,166 where reducible catalytic salts are bonded to formaldehyde resin substrates.

The following list of treatments further exemplify a wide variety of techniques disclosed in U.S. Patents for improving the quality of electroless deposition: (a) substrates of aromatic polyamines are provided with hydroquinone radicals (3,523,874), (b) polystyrene surfaces are treated with ethoxylates (3,533,828), (c) substrates of carboxylic acid polymers are treated with ammonia or alkylenimines (3,567,488 and 3,567,489, respectively), (d) PVC substrates are dehydrohalogenated and oxidized (3,639,153), (e) polymeric surfaces are treated with quaternary amines (3,684,572), (f) hydroxy functional filler is provided in polymer substrates (3,701,675), (g) bipyridyls are incorporated into substrates (3,853,589), (h) cyano-containing resins are incorporated into substrates (4,017,265), (i) substrates are treated hydrosols of compounds having at least two oxygen atoms (4,021,314); (j) substrates are pretreated with phosphorus compounds (4,063,004), (k) substrates are subjected to glow discharge (4,250,225), and (l) discrete crystalline/amorphous regions are developed in polyphenylene sulfide substrates (4,486,463).

In still other cases, e.g. as disclosed in U.S. Patents 3,347,724; 3,523,824 and 3,642,476, particles of reducible catalytic metal compounds have been adhered to a surface by incorporating such compounds into a binder, such as a thermoplastic resin. See also U.S. Patent 3,560,257 where organic compounds of Group 1B and 8 metals are used with a variety of extenders (including polymers) to provide bonding between the substrate and the catalytic organic compound. See also U.S. Patent 3,900,320 which discloses the use of thin polymer layers to provide a readily reducible catalytic metal salt on a substrate. Such layers are formed

2

from polymer solutions where the weight ratio of polymer material to catalytic metal compound is required to be substantially less than about 15 to 1.

US-A-3 904 783 discloses a method for forming a photosensitive layer from an organic binder/metal salt combination in about equiponderal ratios.

Because of the high cost of preferred catalytic metals, e.g. palladium, an objective has been to find ways to utilize lower levels of catalytic metal compound in combination with polymeric binders. In this regard, see U.S. Patent 3,930,109 which discloses the application of thin films from dilute solutions or suspensions of polymeric binder and catalytic compounds; useful films are prepared from polymer solutions containing as little as 0.4 percent palladium chloride based on the weight of the polymer component. See also U.S. Patent 4,493,861 which discloses the use of palladium complexes of (poly)-butadiene from solutions with as low as 5.2 percent by weight of palladium (based on anhydrous polybutadiene). A disadvantage of such films is that the entire film surface is platable by electroless deposition. This means additional process steps are required when plating of less than the entire surface is desired, e.g. as in the production of printed circuitry, selective decoration or selective shielding.

In this regard selectivity in surface coating by electroless deposition has been provided in a variety of ways. For instance, U.S. Patent 3,615,471 discloses methods of making optical masks by coating a transparent plate (e.g. glass) with a transparent photoresist layer comprising, for instance, polyvinyl alcohol and a chromate salt together with a plating catalyst. Such photoresist layer can be exposed to a light pattern and developed (e.g. solvent treated to remove the unexposed part of the layer) to leave a catalytic polymeric pattern which can be electrolessly coated.

Other methods involve the use of photosensitive materials, e.g. to promote reduction of the catalyst metal (see U.S. Patent 3,772,056) or to otherwise generate catalytic nuclei (see U.S. Patents 3,719,49; 3,779,785; 3,900,320; 3,925,578; 3,942,983; 3,959,547; 3,994,727; and 4,560,643.) See also U.S. Patent 3,672,986 which discloses the production of printed circuitry by electrolessly depositing a metal coating over the entire surface of a board substrate. A patterned mask is applied to allow electroplating of the desired circuitry. The mask is removed to allow chemical etching of the undesired portions of the original electroless deposit. Other mask techniques are disclosed in U.S. Patent 3,642,476. See also U.S. Patent 3,656,952 which discloses films containing palladium salts and photosensitive compounds that allow electroless deposition of photographic images.

Other techniques for electroless deposition over selected surfaces, e.g. for printed circuitry, are disclosed in U.S. Patent 4,368,281 where a precursor of the desired circuit is printed with a catalytic ink, e.g. a solution of resin, crosslinker, dye and high levels (5-15% by weight) of palladium complexes. See also U.S. Patent 4,574,095 where vaporized palladium complexes are deposited as clusters on a laser-irradiated pattern of a polymer surface.

Since electroless deposition techniques generally involve a multitude of steps or somewhat sophisticated procedure which, as indicated above, may include pretreatments, etchings, washings, masking, catalyst reduction and the like, there is still a need for simple, effective electroless deposition technology which can utilize low levels of expensive catalyst compounds with minimal waste.

In addition to the above-mentioned difficulties attendant with electroless deposition processes it has been generally found that electrolessly deposited coatings of oxidation susceptible metals, e.g. copper, tend to rapidly discolor and lose their metallic appearance and properties. Prevention of such oxidation is generally achieved by applying a protective coating, for instance, of electrolessly deposited or electroplated nickel, electroplated copper, thermoplastic polymer or thermosetting resin.

## OJBECTS OF THE INVENTION

An object of this invention is to provide articles, such as polymeric films, fibers, foams, etc., with catalytically-inert surfaces that can be activated to provide catalytic surfaces, e.g. to initiate electroless deposition of metals. Such surfaces are desirable activatable by simple techniques, e.g. exposure to radiant energy. Such surfaces should also be selectively activatable without the need to remove surface layers where catalytic activity is not desired or without the need for special photoreactive additives, such as photoactivatable crosslinkers or catalyst reducing agents.

Another object is to provide catalytically-activatable surfaces that are readily adherently applied to a variety of substrates, e.g. rigid or flexible films, fibers, foams etc., and that are amenable to electroless deposition of metals without the difficulties of prior art practices such as etching, pretreatments and the like.

Still another object is to provide such articles with catalytic surfaces that are simple and of low cost requiring low levels of normally expensive catalytic compounds.

A further object of this invention is to provide substantially simplified methods of applying such selectively-activatable catalytic surfaces to articles.

Yet another object is provide substantially simplified methods of electrolessly depositing metal on seletive areas of a uniformly coated substrate, e.g. extremely finely separated areas as required for microcircuitry and data storage devices.

One more object is to provide electrolessly deposited copper coatings having substantially improved oxidation resistance. These and other objects of the invention will be more readily apparent in the following detailed description.

## SUMMARY OF THE INVENTION

It has been discovered that the foregoing objectives can be realized by providing articles with a catalytically-activatable surface layer comprising a complex of at least one polymer with at least one compound of a Group 1B or Group 8 metal (CATALYTIC METAL). Such surface layers are activatable, e.g. by radiant energy, to provide articles having a polymeric surface layer with nascent clusters of at least one Group 1B or Group 8 metal. Such articles can be treated to reduce such nascent clusters to metal clusters thereby providing articles with catalytically-active surfaces. Articles having such catalytically-active surfaces are useful for a variety of catalytic purposes, e.g. as substrates for electrolessly-deposited metal surfaces. Particularly useful articles have an electrolessly-deposited, oxidation-resistant copper surface.

This invention also provides solutions for forming such catalytically-activatible surface layers and methods for preparing and using such articles and solutions.

## BRIEF DESCRIPTION OF THE DRAWINGS

Figures 1 and 2 illustrate the effect of water on certain methods of the invention.

Figure 3 illustrates the effect of metal concentration in several embodiments of methods of the invention.

Figure 4 is an electron micrograph (EM) of an electrolessly-deposited copper coating prepared according to prior art procedures set forth in Comparative Example 17.

Figures 5-8 are EMs of surfaces prepared according to this invention as set forth in Example 17, with Figure 5 showing a polymeric surface having palladium clusters of a nominal dimension of about 10 nanometers and Figures 6-8 showing oxidation-resistant, electrolessly-deposited copper.

## DETAILED DESCRIPTION OF THE INVENTION

Throughout the specification, percentages of compositions are by weight and temperatures are in degrees Celsius, unless indicated otherwise.

"PVC" means polyvinyl chloride.

The term "complex" as used herein refers to organo-metallic combinations where there is molecular interaction, e.g. pi bonding, between polymers used in the films of this invention and solubilized CATALYTIC METAL compounds, for instance such that there is no substantial phase separation between the organic and metallic moieties during film formation.

As used in this specification the term "substantially anhydrous" refers herein to materials useful in the various aspects of this invention that are essentially anhydrous or contain water in such low proportion that performance properties are not materially different than when materials are essentially anhydrous, e.g. there is no substantial reduction in the degree of electroless deposition of metal on a film of such materials.

The term "catalytically inert" refers herein to polymeric layers with non-catalytic surfaces, surfaces onto which metal is not effectively deposited from standard electroless plating solutions such as disclosed in U.S. Patent 3,329,512.

The term "activatable" refers herein to surface layers comprising polymers complexed with CATALYTIC METAL that are substantially catalytically inert but which can be made catalytic, e.g. receptive to effective deposition of metal such as copper, nickel, cobalt and the like from standard electroless plating solutions, by activation of the surface layer. Such activation can be effected by radiant energy, e.g. ultraviolet (UV) light, laser beam, X-rays, electron beams, etc., and/or by heating the surface, conductively or radiantly.

The term "activatably effective amount" refers herein to levels of components used in this invention, e.g. water, that permit activation of surface layers of this invention to the effective electroless deposition of metals. An "activatably effective amount" is to be contrasted with an amount of such component that substantially reduces or inhibits the activation of the surface to electroless deposition. A particular aspect of

4

this invention has been characterized in terms of activatably effective amounts of water, that is the amount of water that can be effectively tolerated in solutions or films of this invention.

The term "oxidation resistance" refers herein to electrolessly deposited layers of metals, in particular copper, that are substantially resistant to oxidation, as compared to electrolessly deposited metal coatings provided by prior art methods. In this regard, one aspect of this invention relates to electrolessly-deposited copper coatings that can be both thin, e.g. typically not more than about 3 micrometer thick, and surprisingly resistant to oxidation. Such oxidation-resistant copper coatings remain optically bright for days, weeks, e.g. up to about 4 months, and longer. Such resistance is an advantageous improvement over electrolessly-deposited copper according to the prior art which readily tarnishes within hours, sometimes within minutes, after deposition.

Polymers that can be useful in providing the complexes in the surface layers of this invention include both saturated and unsaturated polymers. Unsaturated polymers, e.g. polybutadiene, polychloroprene and polyisoprene, are often preferred where there is sufficient unsaturation to provide advantgeous sites for the CATALYTIC METAL to form a complex with the polymer. Other unsaturated polymers including polyactylene, polydiacetylene, allylic polymers, unsaturated rubbers and natural rubbers, certain ethylenepropylene diene monomer rubbers, and copolymers of unsaturated polymers such as ABS, styrene butadiene rubbers and the like can also be employed provided they form complexes with the CATALYTIC METAL compound to form activatable layers.

In other preferred embodiments the polymer is a vinyl polymer, e.g. polyvinyl halides, polyvinyl alcohol, polyvinyl butyral, polystyrene and the like or a halogenated polyolefin such as chlorinated polyethylene. Especially preferred for many applications is PVC which is believed, at least in some cases, to undergo dehydrohalogenation to form a complex with the CATALYTIC METAL compound. Where residual chlorides are undesirable, it is often preferred to use polyvinyl alcohol.

Also expected to be useful in certain embodiments of this invention are other vinyl polymers such as polyvinyl pyrrolidone, polyvinyl acetate, polyvinylidene chloride and the like; polyarylsulfones, polyphenylene ethers, polysulfides such as polyphenylene sulfides; and copolymers and graft copolymers of such saturated and unsaturated polymers.

CATALYTIC METALS that have been found to be useful in complexes with polymers to provide catalytically activated sites for initiation of electroless deposition include gold, platinium, iridium, palladium, rhodium, and ruthenium. It is believed that osmium, which has not been evaluated because of its hazardous nature, and silver would also be useful for initiation of electroless deposition.

In many cases preferred CATALYTIC METALS are palladium and platinium. Palladium is most often preferred. CATALYTIC METALS can be provided with a variety of convenient ligands that have been demonstrated as useful by practitioners in the art. Particularly useful palladium compounds include those where the ligands are nitrates, chlorides, nitriles such as acetonitrile, allylics or mixtures of such ligands or mixtures of compounds having such ligands. An often convenient criterion in selecting the compounds useful in this invention is solubility in the solvents used to provide precursor solutions for films. In this regard because palladium compounds are often of low solubility, it can be useful to enhance their solubility by providing a supplemental source of solubilizing ions such as chloride ions. Such chloride ions can be provided from among the more soluble chloride salts such as lithium chloride or from hydrogen chloride, e.g. either gaseous or as muriatic acid (provided allowance for water content is made as described below).

It has been surprisingly found that catalytically-inert surface layers are advantageously activatable, e.g. selectively catalytically-activatable, when the polymer and CATALYTIC METAL compound are provided at a specific molar ratio based on the number of monomer units of the polymer to the number of atoms of the CATALYTIC METAL (MONOMER/ METAL RATIO). For instance, it has been found that PVC films having a MONOMER/METAL RATIO of at least about 30 to 1 (and in some cases at least about 20 to 1) can be activatable. For instance, in most cases where PVC is complexed with palladium compounds, films are activatable when the MONOMER/ METAL RATIO is not less than about 30 to 1. In some cases, e.g. when such films are formed in low humidity environments, the films are activatable when the MONOMER/METAL RATIO is as low as about 20 to 1, e.g. greater than about 15 to 1. That is, where certain films If PVC complexed with palladium compounds are formed in low humidity environments and the MONOMER/ METAL RATIO is less than about 20 to 1, e.g. about 15 to 1, the films are not catalytically inert but rather will, without surface activation, readily acquire a metal coating when placed in electroless plating solution. Where the polymer is polybutadiene and the metal is palladium, films are activatable when the MONOMER/METAL RATIO is at least about 35 to 1.

More surprisingly, it has been found that such films are selectively activatable. That is, selected portions of the surface of the film can be made activatable while other portions of the film can be advantageously maintained in a catalytically inert condition. Such selective activation, e.g. to electroless deposition, is advantageously provided by a number of methods that will be readily apparent to those skilled in the art such as by exposing selected areas of the surface to ultraviolet light through a patterned mask.

In many cases where the polymer is PVC, it is often preferably desired that the PVC-containing portions of surface layers contain lower levels of CATALYTIC METAL compound such that the MONOMER/METAL RATIO is at least about 60 to 1. For even more economical of often expensive CATALYTIC METALS it is often preferred to use lower levels of CATALYTIC METAL, e.g. such that the MONOMER/METAL RATIO is at least about 90 to 1 or even higher. For instance, it has been found that effective electrolessly-deposited metal coatings can be provided on PVC surface layers where the MONOMER/METAL RATIO is even higher, e.g. as high as about 300 to 1 or even 700 to 1. In some instances suitable electroless deposition can be achieved at MONOMER/METAL RATIOS of several thousand to 1, e.g. as low as about 6000 to 1. Thus it has been surprisingly and advantageously found that polymeric films of this invention, e.g. consisting of PVC and palladium compounds, are selectively activatable, e.g. to electroless deposition, at extremely low levels of CATALYTIC METAL, thus affording an extremely economical use of CATALYTIC METAL.

While not intending to be bound thereby it is believed that the operability of this invention for PVC polymer is attributed to formation of pi-complexes of CATALYTIC METAL compounds with PVC. In this regard it is believed that at least certain CATALYTIC METALS can form pi-enyl complexes with PVC that has been dehydrohalogenated. Accordingly, another aspect of this invention is directed to articles having polymeric surface layers comprising pi-enyl complexes formed from PVC and a CATALYTIC METAL. It is further believed that such pi-enyl complexes have the ability to migrate along polymer chains so that uniformly dispersed complexes generated within a selective area of the polymeric film can migrate to form substantially uniformly distributed clusters of such pi-enyl complexes both at and below the surface of the polymeric layer. Such clusters of complexes which may comprise from about 3 to perhaps about 20 or more, e.g. up to about 150 or even 200, atoms of CATALYTIC METAL are believed readily amenable to reduction by reducing agents, such as formaldehyde, which are commonly found in electroless plating solutions. Reduced CATALYTIC METAL at such clusters is then available to catalytically initiate electroless deposition of metal.

Support for such possible migration of pi-enyl complexes is believed to be provided by surface analysis of films of PVC and palladium compounds according to one embodiment of this invention. Prior to activation such film surfaces exhibit negligible amounts of palladium metal, i.e. less than about 0.1 atom percent, while the concentration in the interior of the film contains as much as about 3 percent by weight of palladium. These films have been shown to be catalytically inert until surface activation whereupon the films become active to electroless deposition and exhibit substantially increased levels of CATALYTIC METAL at the surface. Accordingly, a further aspect of this invention is directed to articles having polymeric surface layers comprising pi-enyl complexes formed from PVC and a CATALYTIC METAL where such films ahve an asymmetric distribution of such complex between the surface of the film and the bulk of the film.

Moreover, certain embodiments of this invention comprise articles films consisting essentially of such complex, e.g. of PVC and CATALYTIC METAL compound. In other embodiments films comprise portions of the complex in mixtures with other polymers or multiphase films, e.g. films comprising distinct phases of complex and phases of other polymers, or block copolymers of complex or even compatible blends of complex and other polymers. To afford uniform electroless deposition on such polymer films it is in many instances generally desired that the polymer phases comprising complex be substantially uniformly dispersed, at least over the surface of the film.

PREPARATION OF FILM-FORMING SOLUTIONS

As stated above, articles of this invention have surface layers where the ratio of monomer units of polymer to the number of atoms of CATALYTIC METAL is sufficiently high that non-activated surface layers are catalytically inert. Accordingly, such ratios, which can be determined by routine experimentation according to the methods disclosed herein, are a characteristic of film-forming solutions of this invention comprising a complex of polymer and CATALYTIC METAL compound; such solutions can be utilized to provide articles with catalytically activatable surface layers.

Solutions for forming catalytically-activatable surface layer films can be provided by methods similar to those described below where the polymer is PVC. Solutions of PVC and CATALYTIC METAL can be prepared by dissolving PVC and CATALYTIC METAL compound in a common solvent. The solvent for such solutions is not considered critical to this invention and can comprise tetrahydrofuran (THF), methylene chloride, cyclohexanone, dimethyl acetamide, and the like, or a mixture of solvents of PVC with solvents for CATALYTIC METAL compounds. In this regard THF has been found to be a particularly useful solvent.

Generally such solutions have been conveniently prepared by adding prepared solutions of the CATALYTIC METAL to prepared solutions of PVC. It is often convenient, but not necessary that both prepared solutions comprise the same solvent, e.g. THF. In other cases, it may be preferable to dissolve the CATALYTICAL METAL compound (many of which are of low solubility) in another solvent.

With palladium compounds, other useful solvents include actone, methyl ethyl ketone, methanol, methyl acetate and ethyl acetate. It is expected that other solvents, including mixtures, can be readily determined by routine experimentation. In some cases, e.g. with compounds of low solubility, it may be useful to add soluble anions to the solvents to assist in dissolution. For instance, with palladium compounds, e.g. Pd-$(NO_3)_2$ or $PdCl_2(CH_3CN)_2$, it has proven useful to add soluble chloride salts, e.g. lithium chloride (LiCl), or acidic chloride, e.g. muriatic acid, to facilitate solubility. In other cases, where anhydrous solutions are not required, water can be used to facilitate solution or even be a major solvent component for the CATALYTIC METAL compound. Although solvent temperatures have been kept low, e.g. generally about room temperature, higher temperature may be useful in expediting the solution of some compounds.

Useful solvents for PVC include THF, methylene chloride, and cyclohexanone. When water is desired in the film-forming solutions, it is, of course, advantageous to use a solvent which is miscible with water at least up to the desired concentration of water, e.g. up to about 8% in the solvent. Since PVC is a major film component, it is generally advantageous to prepare the PVC solutions in concentrations suitable for the intended use. Generally such solutions will be at least about 1% PVC and no higher than about 40% PVC. A convenient concentration will generally be between about 5% and about 20%. When PVC is dissolved in THF, solutions between about 7% and 15% PVC (e.g. about 10% PVC) often have useful properties, e.g. in terms of viscosity, adhesiveness to substrates and film-forming speed.

Such film-forming solutions can comprise from about 1 to about 40 percent polymer. The level of polymer may be adjusted to film-forming conditions, for instance higher levels of polymer may provide higher solution viscosities that may be desirable in forming films on sloped or vertical surfaces from which thinner solutions may flow. It is expected that those skilled in the art will be able to readily adjust process variables such as the level of polymer, solution and/or film-forming temperatures, etc., to provide appropriate surface layers on desired articles. While the level of polymer is not considered critical, it has been found, where the polymer is PVC, that activatable surface layers are advantageously prepared from solutions comprising from about 5 to about 15 percent PVC. What is critical to the solutions of this invention is the relative proportion of polymer to CATALYTIC METAL. Such proportion is conveniently stated in terms of the above-described MONOMER/METAL RATIO. The film-forming solutions of the invention can be cast onto substrates as thin films from which the solvent is evaporated into an environment to provide a residual film of PVC and CATALYTIC METAL compound.

In one aspect of this invention, surface layers are substantially anhydrous films formed from substantially anhydrous film-forming solutions in a substantially anhydrous environment.

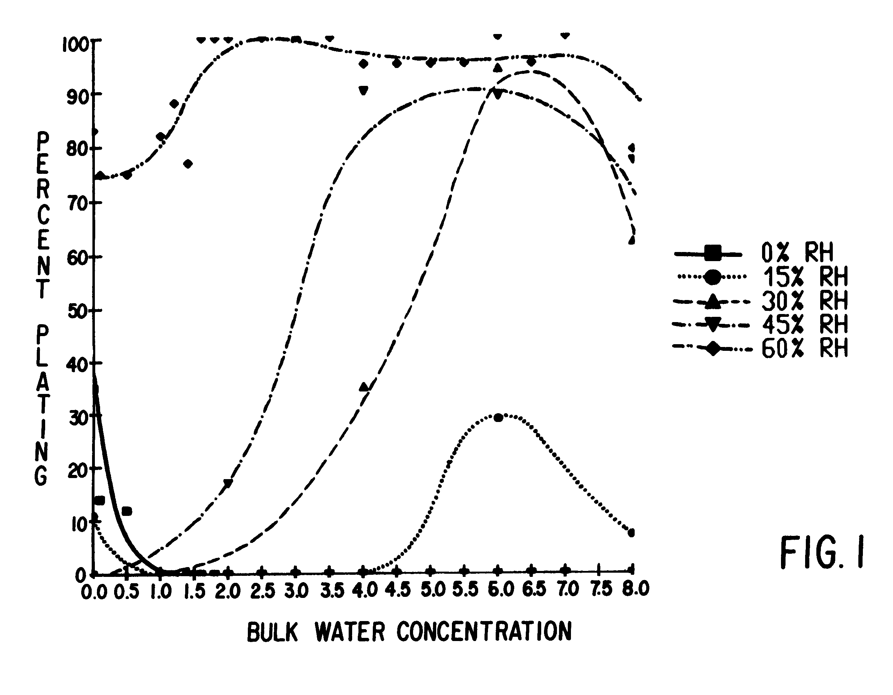

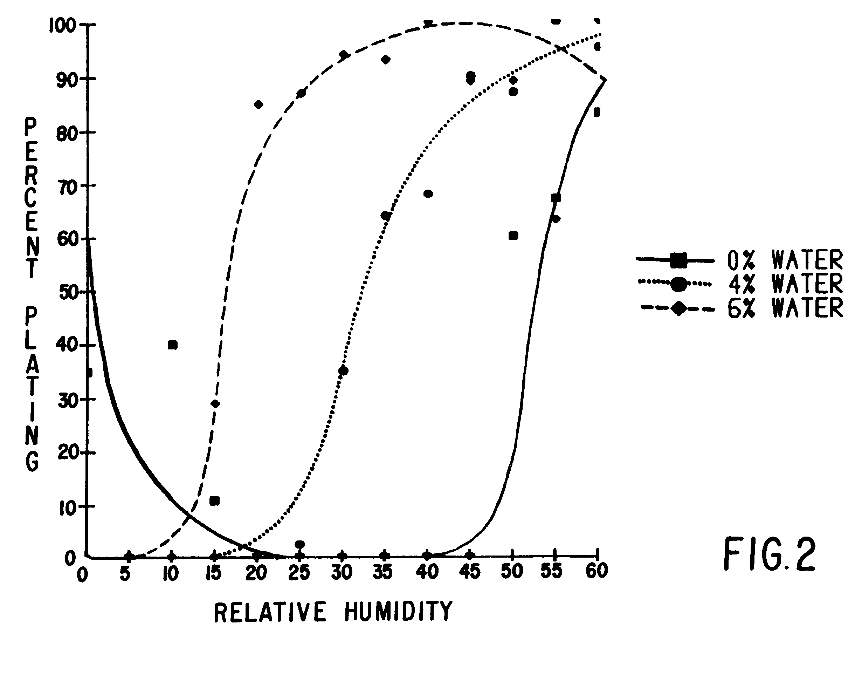

In another aspect of this invention, surface layers comprise films having an activatably effective amount of water. For instance where the polymer is PVC, it has been found that the presence of certain amounts of water in the precursor film-forming solutions adversely affect the ability of the resulting surface layer to be activatable, e.g. to electroless deposition. It has also been found that the presence of certain amounts of water in the environment in which surface layer films are prepared can also adversely affect the ability of surface layer films to be activatable, e.g. to electroless deposition. In this regard reference is made to Figures 1 and 2 which illustrate such effects of water in surface layer films comprising PVC and palladium, where such utility is characterized in terms of "percent plating" which indicates the portion of a film surface area that became coated with a metal in an electroless plating solution. The water-based variables are "bulk water concentration" which is the percentage of water in the solvent of the film-forming solution and "relative humidity" of the environment into which solvent is evaporated from a casting of film-forming solution. The film-forming solution comprised about 10 percent PVC and palladium at a MONOMER/METAL RATIO of about 60 to 1; the organic solvent was THF. Other details are presented in Example 10 below.

What Figure 1 illustrates is that water can be tolerated in certain film-forming solutions provided the solution is formed into a surface layer film in an environment having a sufficiently high level of water, as indicated by relative humidity. Also illustrated is that platable surface layer films can be formed in environments having a wider range relative humidity from solutions where the solvent contains higher levels of water, e.g. about 5-8 percent, than where the solvent contains lower amounts of water, e.g. about 0-2 percent. This latter effect is also illustrated in Figure 2. These figures illustrate more preferred aspects of this invention for films based on PVC and palladium. For isntance, where it is difficult to eliminate ubiquitous water from film-forming solutions or from the environment in which films are formed, it is often desirable that, when the film-forming solution comprises THF solvent, the solvent comprises about 6 percent water, especially when it is difficult to control the relative humidity of the film-forming environment. In other cases, especially where it is difficult to control the amount of water in the solvent, it is often desirable to prepare the surface layer films of this invention in an environment where the relative humidity is at least about 20 percent, more preferably at least about 30 percent or higher. An upper level of relative humidity is believed to be about 80 percent. In this regard it has been found that films formed in an environment of about 85 percent relative humidity have exhibited no selectivity toward activation. That is, such films were readily covered with a metal coating when deposited in an electroless plating solution without activation.

## FORMING ACTIVATABLE SURFACE LAYERS

The film-forming solutions can be used to provide catalytically-activatable surface layers on articles of a variety of shapes, e.g. fibers, films, foams, spheres, fabrics, containers and so forth. Such substrates can also comprise a variety of materials of construction, including organic materials such as natural or synthetic polymers or composites such as cellulose, wood, polyester, etc. or inorganic materials such as ceramics, glass, alumino-silicates, etc. In certain preferred aspects of this invention the substrates comprise films or fibers, e.g. organic or inorganic fibers which are monofilament or multifilament, e.g. a yarn or tow. Useful inorganic fibers can comprise glass, alumina, phosphate and the like; while useful organic fibers can comprise cellulose and its derivatives such as rayon, polyamides such as nylon 6, nylon 6,6 and the like, polyesters such as PET, polyolefins such as polyethylene, polypropylene and the like, acrylics such as acrylontrile polymers and copolymers, polysulfones polyimides, etc. Such exemplary materials for fibers can also be useful in substrates of other shapes.

Because substrate surfaces are often coated with materials such as lubricants or other processing aids which hinder the adhesion of film-forming solutions, it is often necessary to initially remove such materials by washing with detergent or other cleaning solutions, e.g. comprising volatile organic solvents. A particularly useful cleaning solution for cleaning certain polymeric substrates has been found to comprise acidified alcohol, e.g. muriatic acid-containing methanol. If necessary the cleaner can be rinsed from the substrate, e.g. with water. Such water-wetted substrate can be directly immersed in film-forming solutions. In the case of volatile cleaners such rinsing is often not necessary. For instance, cleaning solvent-wetted substrates can be dried in a warm air stream, then coated with film-forming solution.

As indicated in the following examples one embodiment of an article according to this invention comprises self-supporting films formed by casting the film-forming solutions on non-adhesive supports. When sufficient solvent has been removed, e.g. by exposing the surface for about 5-30 minutes to hot air (100-200 C), a self-supporting film can be removed from the support. Depending on the film-forming conditions, e.g. MONOMER/METAL RATIO, amount of water in the solution, relative humidity in the environment, etc., such films can be activatable on either or both surfaces.

Other embodiments of articles with a catalytically-activatable surface layer are provided by coating the article with a film-forming solution of appropriate viscosity to assist in maintaining a desired film thickness. Coating can be effected by spraying, dipping the other procedures practiced in the coatings industry. For instance, fibers can be conveniently run through a bath of film-forming solution and printed circuits can be provided by using the film-forming solutions of this invention as inks to print a precursor catalytically-activatable film corresponding to the desired circuitry. Alternatively, printed circuits can be provided by coating a substrate, e.g. flexible film or rigid laminate, with a film-forming solution to provide a surface layer that can be selectively activated in those areas where circuitry is desired. More specifically, printed circuit board laminates can be advantageously provided with circuitry, e.g. of electrolessly deposited copper, by selectively exposing a catalytically-activatable surface coating to focused light, followed by immersion in an electroless plating solution. Extremely fine circuitry can be provided by surface activation with a laser of controlled, narrow width.

With some substrates, e.g. ABS surfaces, extremely thin surface layers can be achieved by providing a coating with a film-forming solution of PVC and palladium and mechanically delaminating the bulk of the solid film, leaving a residue surface layer, e.g. of PVC complexed with CATALYTIC METAL that is activatable, e.g. to electroless deposition.

Another method of providing activatable surface layers on molded articles comprises applying a film-forming solution to a mold surface corresponding to the desired activatable surface. The solution is solidified to form a catalytically-activatable surface-coated mold. Thermoplastic material cast or injected into the mold will acquire a surface layer that can be selectively activated, e;.g. to electroless deposition. In some cases the molding temperatures or temperatures of molten thermoplastic material may be sufficient to activate the transferred surface layer. Such procedures are useful for providing activated surfaces on the inside surfaces of housings for electronic components, e.g. to provide metal coatings by electroless deposition for shielding against electromagnetic interference.

ARTICLES COMPRISING CATALYTIC METAL CLUSTERS

Articles of this invention having polymeric surface layers comprising nascent clusters of CATALYTIC METAL can be provided by applying energy to the activate the surface layer. Such activation can be effected by exposing catalytically-activatable surface layers to U.V. or other radiation or by heating the surface. A convenient method for activating such surfaces comprises heating the article for about 5 minutes or so in hot air, e.g. 180 C air. Such activated surface layers will comprise nascent clusters and are not catalytically-active, but can be made catalytically-active by exposing the nascent clusters to a reducing agent, e.g. a caustic/formaldehyde solution, to provide reduced CATALYTIC METAL clusters.

Accordingly, articles of this invention having catalytically-active polymer surface layers comprise clusters of CATALYTIC METAL where the molar ratio of monomer units of said polymer to atoms of CATALYTIC METAL is sufficiently high that said surface is catalytically-inert prior to activation by radiant energy to form nascent clusters and subsequent reduction to form the CATALYTIC METAL clusters. Observation of EMs of surface layers prepared according to the methods of this invention indicates that, depending on the duration and intensity of the activation and subsequent reduction steps, the CATALYTIC METAL clusters are provided both on and below the polymeric surface layer. Observation of EMs also indicates that CATALYTIC METAL clusters provided on surface layers according to this invention can advantageously have a nominal dimension not greater than about 100 nanometers, often not greater than about 50 nanometers. In many cases the methods of this invention can be practiced to provide articles with surface layers having CATALYTIC METAL clusters of a nominal dimension not greater than about 20 nanometers, say about 4-15 nanometers. In certain preferred aspects of this invention articles are provided with surface layers having palladium clusters of a nominal dimension not greater than about 10 nanometers.

In the case of PVC complexes with palladium, irradiation, e.g. U.V. radiation, or heating can be useful methods of applying energy for activation. In other cases, e.g. with complexes of polybutadiene or polychloroprene, irradiation rather than heating has been shown to be a useful method of activation. The type of activation selected may depend on factors such as the polymer complex of the film, the topography of the surface layer, the desired catalytic function and the desired selectivity of activation. For instance, it may be advantageous to heat fibers coated with an activatable film to provide a generally activated surface as a precursor to a metal coated fiber. In the case of providing electroless deposition of metal on data storage devices, e.g. laser readable substrates or magnetic readable substrates, it is expected to be advantageous to selectively activate discrete areas with finely focused radiation.

EXAMPLE 1

The purpose of this example is to illustrate embodiments of the following aspects of this invention: the preparation of a film-forming solution comprising PVC and a CATALYTIC METAL compound, the preparation of activatable films from such solution, and the effects of surface activation of such films.

10 g of PVC powder (Geon® 121 by B. F. Goodrich), dried in an oven at 60° for 48 hours, was dissolved under an anhydrous nitrogen atmosphere in 90 grams of dry THF to provide a dry 10% PVC solution.

Palladium dichloride bisacetonitrile (PdCl$_2$BAN) was dried for 48 hours at room temperature under a reduced pressure of about 2.799 Pa (21 millitorr.) LiCl was dried in an oven at 150° for 48 hours. Under an anhydrous nitrogen atmosphere 0.25 g of dry PdCl$_2$BAN and 0.04 g LiCl were dissolved in 1.36 g dry THF to provide a 6% Pd solution (about 15% PdCl$_2$BAN).

An anhydrous film-forming solution was prepared by combining 0.5 g of the 15% solution of PdCl$_2$BAN and 10 g of dry 10% PVC solution to provide a film-forming solution containing about 3% Pd and having a MONOMER/METAL RATIO of about 60 to 1.

The film-forming solution was cast and dried (e.g. solvent evaporated) into films of about 0.01 mm thickness on three glass slides under each of the following three conditions: (a) in a substantially anhydrous nitrogen atmosphere, (b) in a nitrogen atmosphere containing water at about 10% RH (c) in a nitrogen atmosphere containing water at about 85% RH. One set of three films (comprising one film prepared under each of the three conditions) was not subjected to activation. A second similar set of three films was activated by exposure to heat in a 180° oven for 5 minutes. A third similar set of three films, was activated by exposure to U.V. light for about 2 hours (film held about 25 mm from a 254 nanometer wavelength mercury arc lamp receiving radiation about 7.5 milliwatts/square centimeter).

9

Each film was stripped from the glass and immersed for about 5 minutes in a copper electroless plating solution prepared from copper sulfate pentahydrate, Rochelle salt (i.e. potassium sodium tartrate), formalin (i.e. 37% formaldehyde), sodium hydroxide (50%), and ethylenediaminetetraacetic acid (EDTA) to provide a solution (Copper Bath) of the following analysis:

2.5 g/l copper
3 g/l formalin
6 g/l hydroxide ion
22 g/l EDTA
pH 11.5-12.5

The Copper Bath was maintained at about 38° and agitated by a magnetic stir bar.

The results of the plating are found in Table 1 where the plating on the glass side of the film is in parentheses. The following symbols qualitatively indicate the degree of film coverage by a copper coating:

0 (none)
= (very little)
- (little)
+ (substantial)
+ + (total)

TABLE 1

ELECTROLESS DEPOSITION OF COPPER
ON PVC FILMS

CATALYTIC METAL SALT: $PdCl_2BAN$

SOLVENT: DRY THF

CHLORIDE SOURCE: LiCl

| Activation | Film-Forming Environment | | |
| --- | --- | --- | --- |
| | Anhydrous | 10% RH | 85% RH |
| None | 0 (0) | 0 (0) | = (0) |
| Heat | + (+) | ++ (+) | ++ (-) |
| U.V. | ++ (+) | ++ (0) | - (-) |

EXAMPLE 2

In the manner of Example 1, this example serves to illustrate similar aspects of this invention where the CATALYTIC METAL compound is palladium dichloride ($PdCl_2$). The procedures of Example 1 are repeated except that 0.17 g of $PdCl_2$ is used to prepare the 6% Pd solution.

The results of the electroless deposition are found in Table 2.

## TABLE 2
### ELECTROLESS DEPOSITION OF COPPER
### ON PVC FILMS
CATALYTIC METAL SALT: $PdCl_2$

SOLVENT: DRY THF

CHLORIDE SOURCE: LiCl

| Activation | Film-Forming Environment | | |
|---|---|---|---|
| | Anhydrous | 10% RH | 85% RH |
| None | 0 | 0 | = |
| Heat | + (+) | ++ (+) | ++ (-) |
| U.V. | ++ (+) | ++ (0) | - (-) |

## EXAMPLE 3

In the manner of Example 1, this example serves to illustrate similar aspects of this invention except where the CATALYTIC METAL compound is palladium nitrate ($Pd(NO_3)_2$). The procedures of Example 1 are repeated except that 0.22 g of $Pd(NO_3)_2$ is used to prepare the 6% Pd solution. The results of the electroless deposition are found in Table 3.

## TABLE 3
### ELECTROLESS DEPOSITION OF COPPER
### ON PVC FILMS
CATALYTIC METAL SALT: $Pd(NO_3)_2$

SOLVENT: DRY THF

CHLORIDE SOURCE: LiCl

| Activation | Film-Forming Environment | | |
|---|---|---|---|
| | Anhydrous | 10% RH | 85% RH |
| None | 0 | 0 | = |
| Heat | 0 (+) | ++ (+) | ++ (-) |
| U.V. | = (0) | - (+) | 0 (0) |

## EXAMPLE 4

In the manner of Examples 1, 2 and 3, this example serves to illustrate the distinct aspects of similar embodiments of this invention where muriatic acid is used instead of LiCl to assist in dissolution of the palladium compound. The procedures of Examples 1, 2 and 3 are repeated except that 0.09 g of 37% HCl is used in place of 0.04 g LiCl. The results are shown in Table 4.

EXAMPLE 5

In the manner of Examples 1, 2 and 3, this example serves to illustrate the distinct aspects of similar embodiments of this invention where an activatably effective amount of water is incorporated into the solvent. The procedures of Examples 1, 2 and 3 are repeated except that the solvent comprises 6% water in THF. The results are shown in Table 5.

### TABLE 4
### ELECTROLESS DEPOSITION OF COPPER
### ON PVC FILMS

| Activation | Film-Forming Environment | | |
|---|---|---|---|
| | Anhydrous | 10% RH | 85% RH |
| **Catalytic Metal Salt: $PdCl_2BAN$** | | | |
| None | 0 | 0 | ++ |
| Heat | = (+) | 0 (+) | - (-) |
| U.V. | ++ (-) | ++ (-) | - (0) |
| **Catalytic Metal Compound: $PdCl_2$** | | | |
| None | 0 | 0 | + |
| Heat | = (+) | 0 (-) | - (-) |
| U.V. | ++ (-) | ++ (-) | = (0) |
| **Catalytic Metal Salt: $Pd(NO_3)_2$** | | | |
| None | 0 | 0 | + |
| Heat | ++ (0) | 0 (+) | ++ (-) |
| U.V. | ++ (-) | ++ (-) | - (=) |

## TABLE 5

### ELECTROLESS DEPOSITION OF COPPER ON PVC FILMS

| Activation | Film-Forming Environment | | |
|---|---|---|---|
| | Anhydrous | 10% RH | 85% RH |
| **Catalytic Metal: PdCl$_2$BAN** | | | |
| None | 0 | 0 | = |
| Heat | ++ (+) | ++ (+) | = (-) |
| U.V. | ++ (0) | = (0) | - (-) |
| **Catalytic Metal: PdCl$_2$** | | | |
| None | 0 | = | = |
| Heat | ++ (+) | ++ (+) | - (-) |
| U.V. | ++ (0) | = (0) | = (-) |
| **Catalytic Metal: Pd(NO$_3$)$_2$** | | | |
| None | 0 | + | |
| Heat | 0 (+) | ++ (++) | |
| U.V. | 0 (0) | = (0) | |

### EXAMPLE 6

This example serves to illustrate that aspect of this invention where a film can be stripped from a substrate to provide a substantially thinner residual layer that is activatable.

The film-forming solution of Example 3 was cast onto a sheet of ABS in an anhydrous nitrogen environment. The bulk of the film based on PVC and Pd(NO$_3$)$_2$ was readily stripped from the ABS sheet. The ABS sheet was then irradiated by U.V. light for about 18 hours and immersed in a Copper Bath. A uniform copper coating was deposited on the surface of the ABS sheet from which the film had been stripped.

### EXAMPLE 7

This example serves to illustrate that gold, a Group 1B metal, is useful in embodiments of this invention. A film-forming solution was prepared essentially as in Example 1 except that HAuCl$_4$ • nH$_2$O was used as the CATALYTIC METAL compound to provide a solution having a MONOMER/METAL ratio of about 20:1. Films were prepared on glass slides in a nitrogen environment at 64% RH. Films were either (a) not activated, (b) activated by heat (180° for 5 minutes) or (c) activated by light (U.V. exposure for 24 hours) prior to immersion in a Copper Bath for 3 minutes. A copper coating was deposited only on the activated films.

### EXAMPLE 8

This example serves to illustrate that ruthenium, rhodium, iridium and platinum (Group 8 metals) are useful in embodiments of this invention. Film-forming solutions were prepared essentially as in Example 1 using each of the following as CATALYTIC METAL compounds: PtCl$_2$(CH$_3$CN)$_2$, RhCl$_3$ • nH$_2$O, H$_2$PtCl$_6$ • nH$_2$O, RuCl$_3$ • nH$_2$O, H$_2$IrCl$_6$ • nH$_2$O, IrCl$_3$ • nH$_2$O, and PdCl$_2$BAN where the MONOMER/METAL ratio was about 20:1.

Films were prepared on glass slides under a nitrogen environment at 64% RH. Without further activation the films based on $H_2PtCl_6 \cdot nH_2O$ and $PdCl_2(CH_2CN)_2$ were active to electroless deposition from a Copper Bath. The other films, even when activated by heat (180° for 5 minutes) or light (U.V. for 24 hours) did not become copper coated to any visible extent.

Additional films were prepared on glass slides under a nitrogen environment at about 3% RH. After activation by light (U.V. for 24 hours) both platinum-based films exhibited some copper coating after immersion in a Copper Bath. After activation by heat (180° for 5 minutes) and immersion in a Copper Bath, a metal coating was visible on the rhodium, platinum, ruthenium, iridium and palladium based films.

EXAMPLE 9

This example serves to illustrate the concept of an activatably effective amount of water in embodiments of this invention.

Film-forming solutions were prepared essentially as in Example 1 except that water was added to individual volumes of the solution to provide the solutions indicated in Table 6 where water concentration is based on the weight of THF solvent and water.

Films were cast onto glass slides using film-forming solutions in nitrogen film-forming environments having water ranging from 0-60% RH as indicated in Table 6. The films were activated by heat (180° for 5 minutes) and then immersed in a Copper Bath. The effects of water content in the solvent and in the film-forming environment were quantified by projecting photographic slides of each film onto graph paper. The percent plating, determined by the ratio of the projected area having a copper coating to the projected area of the entire PVC film, is indicated in Table 6.

Portions of the results are also graphically presented in Figures 1 and 2.

### TABLE 6

### COPPER COATING OF PVC FILMS
### PERCENT OF FILM AREA COATED

| Solvent % $H_2O$ | Film-Forming Environment, % RH in Nitrogen | | | | | | | | | | | | |
|---|---|---|---|---|---|---|---|---|---|---|---|---|---|
| 0 | 0 | 5 | 10 | 15 | 20 | 25 | 30 | 35 | 40 | 45 | 50 | 55 | 60 |
| 0 | 35 | 0 | 40 | 11 | 0 | 0 | 0 | 0 | 0 | 0 | 60 | 67 | 83 |
| 0.1 | 14 | - | 2.6 | - | - | - | - | - | - | - | - | - | 75 |
| 0.5 | 12 | - | - | - | - | - | - | - | - | - | - | - | 75 |
| 1 | 0 | 0 | 3.2 | 0 | 0 | 0 | 0 | 0 | 0 | 0 | 60 | 76 | 82 |
| 1.2 | 0 | - | 15 | - | - | - | - | - | - | - | - | - | 88 |
| 1.4 | 0 | - | 0 | - | - | - | - | - | - | - | - | - | 77 |
| 1.6 | 0 | - | 0 | - | - | - | - | - | - | - | - | - | 100 |
| 1.8 | 0 | - | 0 | - | - | - | - | - | - | - | - | - | 100 |
| 2.0 | 0 | 0 | 2.1 | 0 | 0 | 0 | 0 | 0 | 31 | 17 | 29 | 70 | 100 |
| 2.5 | 0 | - | 0 | - | - | - | - | - | - | - | - | - | 100 |
| 3.0 | 0 | - | 0 | - | - | - | - | - | - | - | - | - | 100 |
| 3.5 | 0 | - | 0 | - | - | - | - | - | - | - | - | - | 100 |
| 4.0 | 0 | 0 | 0 | 0 | 0 | 2.5 | 35 | 64 | 68 | 90 | 87 | 100 | 95 |
| 4.5 | 0 | - | 0 | - | - | - | - | - | - | - | - | - | 95 |
| 5.0 | 0 | - | 0 | - | - | - | - | - | - | - | - | - | 95 |
| 5.5 | 0 | - | 0 | - | - | - | - | - | - | - | - | - | 95 |
| 6.0 | 0 | 0 | 0 | 29 | 85 | 87 | 94 | 93 | 100 | 89 | 89 | 63 | 100 |
| 6.5 | 0 | - | 0 | - | - | - | - | - | - | - | - | - | 95 |
| 7.0 | 0 | - | 0 | - | - | - | - | - | - | - | - | - | 100 |
| 8.0 | 0 | 0 | 0 | 7.3 | 22 | 58 | 62 | 46 | 56 | 77 | 59 | 26 | 79 |

EXAMPLE 10

This example serves to illustrate the wide range of MONOMER/METAL RATIO that can be utilized in embodiments of this invention.

Separate volumes of film-forming solution, with MONOMER/METAL RATIO as indicated in Table 7, were prepared by mixing the 10% PVC solution of Example 1 with THF dilutions of the 6% Pd solution of Example 1. Films were cast onto glass slides from each solution under nitrogen environments of 0, 10 and 60% RH, activated by heat (180° for 5 min.) and immersed in a Copper Bath. Percent plating, determined as in Example 9, is reported in Table 7.

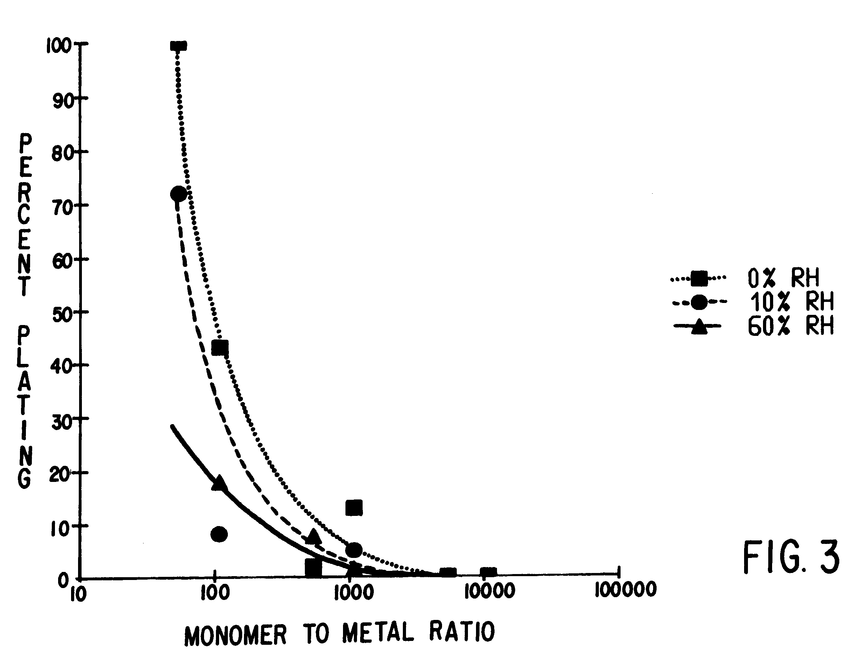

A semi-log plot of the results, Figure 3, indicates that plating can be achieved at MONOMER/METAL RATIOS of less than about 5400 to 1.

15

### TABLE 7

### COPPER COATING OF PVC FILMS
### PERCENT OF FILM AREA COATED

| MONOMER METAL | FILM FORMING ENVIRONMENT, % RH IN NITROGEN | | |
|---|---|---|---|
| | 0 | 10 | 60 |
| 54 | 100 | 72 | - |
| 108 | 43 | 8.3 | 18 |
| 540 | 2 | 0 | 7.8 |
| 1080 | 13 | 5.1 | 1.5 |
| 5400 | 0 | 0 | 0 |

EXAMPLE 11

This example serves to illustrate the significance of MONOMER/METAL RATIO in distinguishing activatable films of polymer complexed with CATALYTIC METAL from films that are not activatable.

10% PVC solution and 6% Pd solution, prepared essentially as Example 1, were combined to provide four film forming solutions having MONOMER/METAL RATIOS of 15 to 1, 20 to 1, 25 to 1 and 30 to 1. Each solution was used to prepare films in nitrogen environments at low humidity (about 10% RH). For each solution, films were either (a) not activated, (b) activated by light (U.V. for 2½ hours), or (c) activated by heat (180° for 5 minutes) prior to immersion in a Copper Bath.

A visual estimate of percent plating (based on film area) shown in Table 8 indicates that for films of complexes of PVC and palladium, a MONOMER/METAL RATIO of greater than about 15 to 1 is required for activatable films.

### TABLE 8

### PERCENT PLATING OF
### ELECTROLESSLY-DEPOSITED COPPER

| Activation | Time in Bath | MONOMER/METAL RATIO | | | |
|---|---|---|---|---|---|
| | | 15:1 | 20:1 | 25:1 | 30:1 |
| None | 2 min. | 100 | <2 | 0 | 0 |
| U.V. | 2 min. | 100 | 90 | 0 | 5 |
| Heat | 1/2 min. | 100 | 100 | 100 | 100 |

EXAMPLE 12

The example serves to illustrate embodiments of the following aspects of this invention: the preparation of film-forming solutions of polybutadiene and a CATALYTIC METAL compound, the preparation of activatable films from such solutions, the activation of such films, and the electroless deposition of copper onto such activated films.

5 g of polybutadiene rubber (Diene 55™ by Firestone, Mw: 240,000; Mn: 105,000) was broken into small particles and dissolved in 70 g of THF to provide a 6.7% polybutadiene solution.

The polybutadiene solution was mixed with a 6% Pd solution (prepared essentially as in Example 1) in various proportions to provide solutions of each of the MONOMER/METAL RATIOS indicated in Table 9.

16

Each of the solutions was cast into thin films on glass slides in nitrogen environments at room temperature both at high humidity (about 60-80% RH) and at low humidity (about 10% RH).

As indicated in Table 9 films prepared from each solution at each of the film-forming conditions were either (a) not activated, (b) activated by heat (180° for 5 minutes), (c) activated by light (U.V. for 2½ hours as indicated in Example 1), or (d) activated by light (U.V. for about 24 hours), prior to immersion in a Copper Bath for about 2 minutes.

A visual estimate of percent plating (based on film area) shown in Table 9 indicates that for films of complexes of polybutadiene and palladium, a MONOMER/METAL RATIO of at least about 35 to 1 (in some cases at least about 40 to 1 or higher, say about 50 to 1) is required for activatable films.

## TABLE 9

### PERCENT PLATING OF ELECTROLESSLY-DEPOSITED COPPER

| Activation | Monomer/Metal Ratio | | | | | | |
|---|---|---|---|---|---|---|---|
| | 20:1 | 25:1 | 30:1 | 35:1 | 40:1 | 45:1 | 50:1 |
| **(a) Film formed at high humidity (62-80% RH)** | | | | | | | |
| None | 100 | 100 | 95 | 80 | 30 | 20 | 10 |
| U.V. (2½ hours) | 100 | 100 | 100 | 100 | 100 | 100 | 100 |
| Heat | 100 | 100 | 95 | 25 | 30 | 0 | 0 |
| **(b) Film formed at low humidity (about 10% RH)** | | | | | | | |
| None | 100 | 75 | 60 | 30 | <1 | 0 | 5 |
| U.V. (2½ hours) | 100 | 100 | 100 | 85 | 60 | <5 | 25 |
| U.V. (24 hours) | 100 | 100 | 100 | 100 | 100 | 100 | 90 |

### EXAMPLE 13

This example serves to illustrate embodiments of the following aspects of this invention: the preparation of the film-forming solutions of polychloroprene and a CATALYTIC METAL compound, the preparation of activatable films from such solutions, the activation of such films and the electroless deposition of copper onto such activated films.

5 g of polychloroprene rubber (from Aldrich Chemical Company, 10% cis isomer) was broken into small particles and dissolved in 65 g of THF to provide a 7.1% polychloroprene solution.

1 part of a 6% Pd solution, prepared essentially as in Example 1, was added to 20 parts of the 7.1% polychloroprene solution to provide a film-forming solution having a MONOMER/METAL RATIO of about 28 to 1.

As indicated in Table 10 films were cast on glass slides in nitrogen environments at room temperature both at a low humidity (about 8% RH) and at a high humidity (about 60% RH); such films were either (a) not activated, (b) activated by heat (180° for 5 minutes) or (c) activated by U.V. light (about 10 hours), prior to immersion in a Copper Bath.

A visual estimate of percent plating (based on film area) shown in Table 10 indicates that such films of complexes of polychloroprene and palladium are activatable.

17

## TABLE 10
## PERCENT PLATING OF ELECTROLESSLY-DEPOSITED COPPER

| Activation | Film-Forming Environment, Nitrogen | |
|---|---|---|
| | 8% RH | 60% RH |
| None | <2 | 0 |
| Heat | 0 | 0 |
| U.V. | 90 | 95 |

EXAMPLE 14

This example serves to illustrate the application of the method of this invention to providing copper-coated acrylic fibers.

A length of 2.2 denier, multifilament acrylic fibers of a copolymer of acrylonitrile and vinyl acetate (93:7) was passed at a rate of about 20 cm/min sequentially through the following three solutions: (a) Cleaning Solution of 2 ml of 38% HCl in 98 ml methanol, (b) water, and (c) an anhydrous film-forming solution essentially according to Example 1. The immersion time in each solution was about 30-45 seconds. The wetted fiber bundle was dried for about 1 minute in a nitrogen stream, then for about 20 minutes in air at 190 C. The dried fiber was immersed for about 6 minutes in Copper Bath. Wet copper-coated fiber was wound on a spool and dried at 60 C. The dry, copper coating was oxidation resistant and exhibited an electrical resistance along the fiber bundle length of about 75 ohms/meter.

EXAMPLE 15

This example serves to illustrate the preparation of nickle-coated polyester fiber.

A length of 1000 denier, multifilament PET yarn was immersed for about 45-50 seconds in a catalyst solution (a film-forming solution of Example 1 except the solution comprised 0.1% PVC and had a PVC monomer unit/Pd atom ratio of about 2:1). The catalyst solution-wetted yarn was dried for about 1 minute in a dry nitrogen stream and the for about 30 minutes in 180 C air. The dried yarn was stored on a spool for a day. The yarn was then heated for about 5 minutes in 170 C air, immersed for about 1 minute in a nickel electroless deposition solution to provide a yarn comprising nickel-coated PET fibers.

EXAMPLE 16

This example serves to illustrate embodiments of solutions of this invention based on a variety of polymers; articles (fibers and films) having polymeric surface layers made from such solutions, where the surface layers are (a) catalytically-inert, (b) catalytically-active, and (c) coated with electrolessly-deposited metal (e.g. oxidation-resistant copper).

Film-forming solutions (10% polymer) were prepared essentially as in Example 1 using PVC and also for polyvinyl butyral (PVB), polyvinyl alcohol (PVOH), polystyrene (PS), and chlorinated polyethylene (CPE); film-forming solutions (5% polymer) were prepared by adding THF to 10% solutions of PVC, PS and CPE.

PET fibers were washed in acidified methanol, dipped in the film-forming solution as indicated in Table 11 and dried for 5 minutes in air (22 C, 30% R.H.), except that fibers dipped in 5% solutions were dried for 10 minutes in dry nitrogen. The resulting fibers having an activatable surface were activated byheating for 5 minutes in hot air (180 C) and then immersed for 4 minutes in Copper Bath to produce copper-coated fibers. The electrical resistance of such copper-coated fibers is reported in Table 11.

## TABLE 11

| Film-forming Solution | Electrical Resistance |
| --- | --- |
| 10% PVC | 6 k  ohms/meter |
| 10% PS | 8 k |
| 10% CPE | 1 k |
| 5% PVC | 1 k |
| 5% PS | not measured |
| 5% CPE | not measured |

Thin strips of each 10% film-forming solution were spread from a pipette onto the surface of printed circuit board laiminate of glass fiber-reinforced epoxy sheets. The solutions were dried for 15 minutes in air (22 C, 38% R.H.) and immersed in Copper Bath. A dull copper coating was deposited on portions of the PVOH, CPE and PS layers. The procedure was repeated except that the dried strips were activated by heating for 3.5 minutes in air (170 C) before immersion in the Copper Bath. The polymer strips were completely covered with oxidation-resistant copper.

COMPARATIVE EXAMPLE 17

This example serves to illustrate the electroless deposition of copper onto polymeric substrates, i.e. ABS graft copolymer, according to the methods of the prior art.

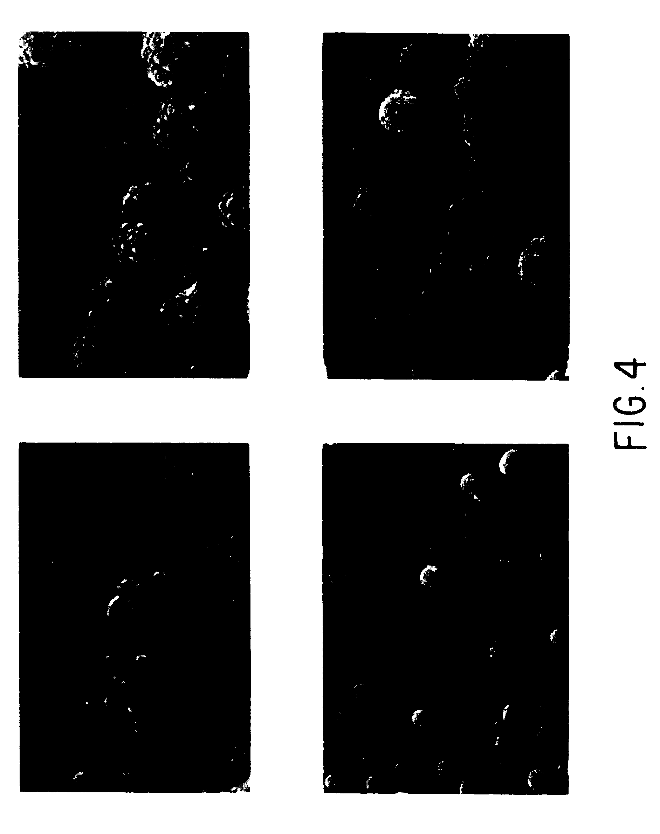

An ABS sheet (about 6 mm thick) etched in a mixture of chromic and sulfuric acid, neutralized with HCl, activated with colloidal palladium chloride/stannous chloride, activated with a borate and electrolessly plated with copper essentially according to the method of Example 1 of U.S. Patent 3,532,518, incorporated herein by reference. The immersion time in Electroless Deposition Solution was 3 minutes. The copper coating was severely tarnished to a blackened surface within a few hours. EMs of the copper surface at magnifications of 5.32, 10.54, 20 and 40 thousand (K) are presented as Figure 4. Observation of the EMs discloses that the surface comprises nodules of copper with pores of a volume substantially greater than a 250 nanometer-sided cube. Such large pores are believed to contribute to the lack of oxidation resistance of such surfaces.

EXAMPLE 17

This example serves to illustrate several aspects of inventions disclosed herein, e.g. the preparation of surfaces having nascent clusters of palladium, the reduction of such nascent clusters to reduced palladium clusters of a nominal dimension not substantially greater than about 10 nanometers, and the electroless deposition of oxidation-resistant copper onto such surfaces and the surface characterization of such copper coatings.

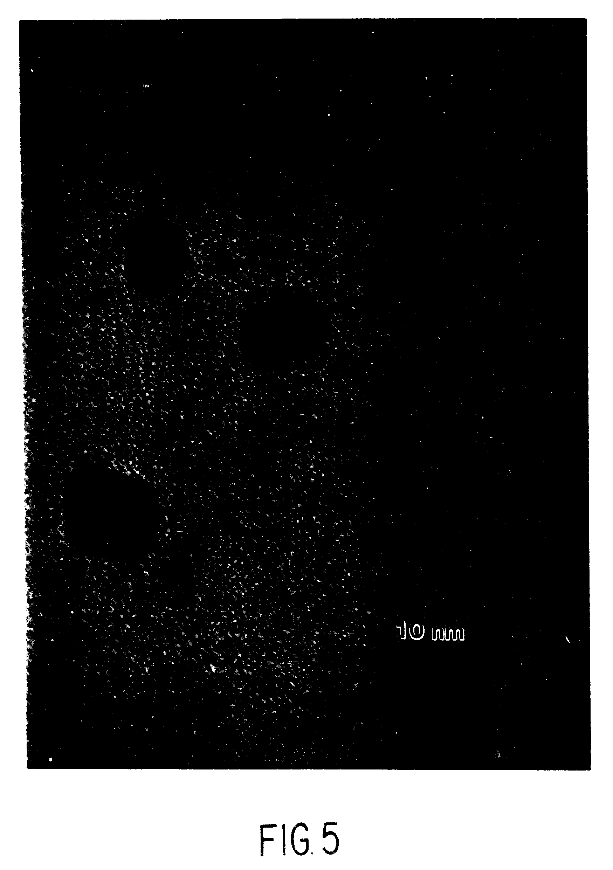

An ABS sheet (about 6 mm thick) was coated with the film-forming solution of Example 1, the coating was dried to form a polymeric surface layer. The film was heated for about 5 minutes in 180 C air to provide the sheet with a polymeric surface layer having nascent clusters of palladium of a nominal dimension not substantially greater than about 10 nanometers. Analysis by ESCA indicated the presence of reduced or ionic palladium on the surface; the presence of reduced palladium on the surface was not indicated by electron microscopy. Subsequent reduction by immersion in a solution of formaldehyde and sodium hydroxide, e.g. Copper Bath prepared without copper sulfate, produces a surface comprising reduced palladium clusters. Figure 5 is an EM of such a surface. The cluster closest to the center of Figure 5 has a diagonal measurement (nominal dimension) of about 10 nanometers. X-ray crystallography of an EM-isolated cluster indicated non-oxidized palladium crystal of octahedral morphology, (111) Miller indices, and crossed lattice planes at 0.225 nanometer spacing.

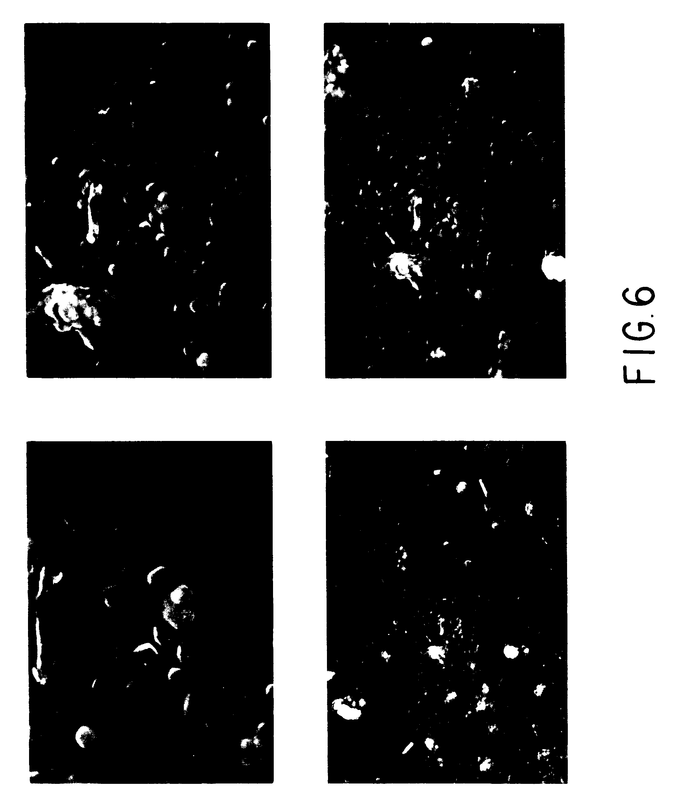

Another ABS sheet having a polymeric surface with nascent palladium clusters, prepared as above-indicated in this example, was immersed for about 3 minutes in Copper Bath to simultaneously reduce the palladium and provide a copper coating which was palladium and provide a copper coating which was substantially oxidation resistant. EMs of the copper coating are presented as Figure 6.

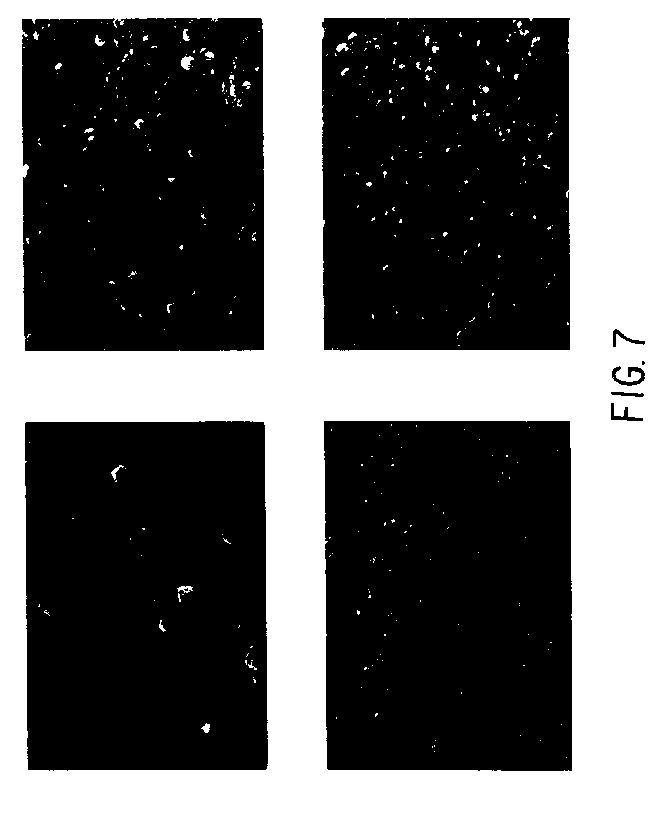

Another ABS sheet was coated with film-forming solution of Example 1 to provide the sheet with a polymeric surface layer. The dried polymeric film was stripped from the ABS sheet leaving a thin residue surface layer. The ABS sheet was heated for about 5 minutes in 180 C air to provide the sheet with a coating having nascent clusters of palladium. The sheet was immersed in Copper Bath for about 3 minutes to provide the sheet with a copper coating which was substantially oxidation resistant. EMs of the copper coating are presented as Figure 7.

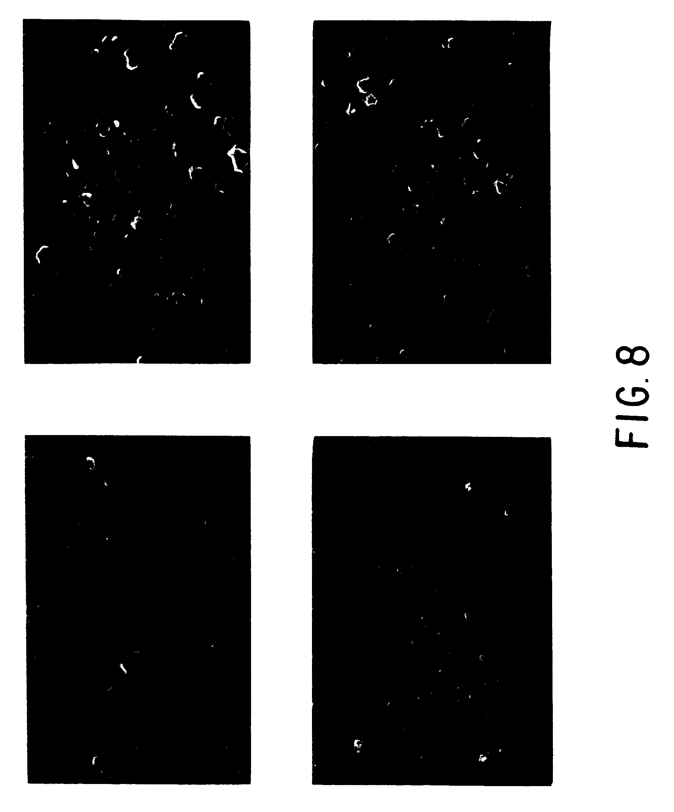

A glass slide was coated with film-forming solution of Example 1 to provide the glass with a polymeric surface coating. The dried polymeric film was heated for about 5 minutes in 180 C air, then immersed for about 3 minutes in Copper Bath to provide a laminate comprising a glass substrate, an intermediate polymeric layer and an oxidation-resistant, electrolessly-deposited copper layer. EMs of the copper surface are presented as Figure 8.

The EMs of Figures 6, 7 and 8 show the surface at nominal magnifications of 5, 10, 20 and 40 K. Observation of the EMs discloses substantially smooth surfaces as compared to the prior art, e.g. as illustrated by Figure 4, and substantially no pores of a volume greater than a 250 nanometer cube. Such smooth surfaces as manifested by a lack of pores common to the prior art is believed to contribute to the high degree of oxidation resistance, i.e. a lack of tarnish over a long period of time, e.g. days, weeks and often months or longer.

## Claims

1. An article having a layer comprising a film of at least one polymer complexed with at least one compound of a Group 1B or Group 8 metal, wherein said layer is formed as a catalytically-inert surface which is selectively activatable to electroless deposition by exposure to radiant energy or heat, characterized in that said polymer and compound are present in the layer in the molar ratio of monomer units of said polymer to atoms of said metal of at least 20:1.

2. An article according to claim 1 wherein selected areas of said layer are activated to electroless deposition.

3. An article according to claim 1 wherein selected areas of said polymeric surface layer have electrolessly deposited metal thereon.

4. An article according to any of claims 1 to 3 wherein said polymer is a vinyl polymer or an unsaturated polymer and said metal is palladium, platinum, iridium, ruthenium, rhodium, osmium, gold, silver or a mixture thereof.

5. An article according to claim 4 wherein said metal is palladium.

6. An article according to any of claims 1 to 5 wherein the concentration of palladium in areas of said layer that are not activated to electroless deposition is less than 0.1 atom percent of palladium at the film surface.

7. An article according to claim 6 wherein areas of said layer that are catalytically inert are activatable to electroless deposition by exposure for up to 24 hours to UV radiation at about 7.5 milliwatts/square centimeter from a 254 nanometer wavelenght mercury arc lamp at about 25 millimeters from said film surface or by exposure to heat in a 180°C oven for 5 minutes.

8. An article according to claim 3 wherein said electrolessly deposited metal is copper having a grain size of up to about 250 nanometers.

9. An article according to claim 3 wherein said electrolessly deposited copper is oxidatively resistant, remains tarnish free and bright for a period up to about 4 months and has a substantially smooth surface and substantially no pores of a volume greater than 250 nanometer sided cube.

10. A film-forming solution comprising at least one polymer and at least one compound of a Group 1B or Group 8 metal, said solution being adapted to providing catalytically-inert films that can be selectively activated to catalyse electroless deposition of metal by the application of radiant energy or heat, characterized in that the polymer and compound are provided so that the molar ratio of monomer units of said polymer to atoms of said metal is at least 20:1.

11. A solution according to claim 10 wherein said polymer is a vinyl polymer or an unsatured polymer and said metal is palladium, platinum, iridium, ruthenium, rhodium, osmium, gold, silver or a mixture thereof.

12. A solution according to claim 11 wherein said polymer is selected from the group consisting of polybutadiene, polychloroprene and polyisoprene.

## Patentansprüche

1. Artikel, welcher eine Schicht, die einen Film aus zumindest einem mit zumindest einer Verbindung eines Gruppe 1B-Metalls oder Gruppe 8-Metalls komplexierten Polymer umfaßt, aufweist, wobei die Schicht als katalytisch inerte Oberfläche gebildet ist, die selektiv durch Bestrahlung mit Strahlungsenergie oder Einwirkung von Wärme für eine stromlose Abscheidung aktivierbar ist, dadurch gekennzeichnet, daß das Polymer und die Verbindung in der Schicht in einem Molverhältnis der Monomereinheiten des Polymers zu den Atomen des Metalls von zumindest 20:1 vorliegen.

2. Artikel nach Anspruch 1, bei welchem ausgewählte Bereiche der Schicht für eine stromlose Abscheidung aktiviert werden.

3. Artikel nach Anspruch 1, bei welchem ausgewählte Bereiche der Polymer-Oberflächenschicht stromlos abgeschiedenes Metall darauf aufweisen.

4. Artikel nach einem der Ansprüche 1 bis 3, bei welchem das Polymer ein Vinylpolymer oder ein ungesättigtes Polymer ist, und das Metall Palladium, Platin, Iridium, Ruthenium, Rhodium, Osmium, Gold, Silber oder eine Mischung hievon ist.

5. Artikel nach Anspruch 4, bei welchem das Metall Palladium ist.

6. Artikel nach einem der Ansprüche 1 bis 5, bei welchem die Konzentration von Palladium in Bereichen der Schicht, die nicht für eine stromlose Abscheidung aktiviert werden, weniger als 0,1 Atom-% Palladium an der Filmoberfläche beträgt.

7. Artikel nach Anspruch 6, bei welchem Bereiche der Schicht, die katalytisch inert sind, durch Bestrahlung mit UV-Strahlung bei etwa 7,5 mW/cm$^2$ von einer Quecksilberbogenlampe mit einer Wellenlänge von 254 nm in einer Entfernung von etwa 25 mm von der Filmoberfläche während bis zu 24 Stunden oder durch Einwirkung von Wärme in einem Heizschrank während 5 Minuten bei 180°C für eine stromlose Abscheidung aktivierbar sind.

8. Artikel nach Anspruch 3, bei welchem das stromlos abgeschiedene Metall Kupfer mit einer Korngröße von bis zu etwa 250 nm ist.

9. Artikel nach Anspruch 3, bei welchem das stromlos abgeschiedene Kupfer oxidationsbeständig ist, während eines Zeitraums von bis zu 4 Monaten beschlagfrei und hell bleibt und eine im wesentlichen glatte Oberfläche sowie im wesentlichen keine Poren, die ein größeres Volumen als ein Würfel mit einer Seitenlänge von mehr als 250 nm haben, aufweist.

10. Filmbildungslösung, welche zumindest ein Polymer und zumindest eine Verbindung eines Gruppe 1B- oder Gruppe 8-Metalls umfaßt, wobei die Lösung geeignet ist, katalytisch inerte Filme vorzusehen, die selektiv durch das Anlegen von Strahlungsenergie oder Wärme für die Katalyse einer stromlosen Abscheidung von Metall aktiviert werden können, dadurch gekennzeichnet, daß das Polymer und die Verbindung derart vorgesehen sind, daß das Molverhältnis der Monomereinheiten des Polymers zu den Atomen des Metalls zumindest 20:1 beträgt.

11. Lösung nach Anspruch 10, worin das Polymer ein Vinylpolymer oder ein ungesättigtes Polymer ist, und das Metall Palladium, Platin, Iridium, Ruthenium, Rhodium, Osmium, Gold, Silber oder eine Mischung

21

EP 0 271 466 B1

hievon ist.

**12.** Lösung nach Anspruch 11, worin das Polymer aus der Gruppe bestehend aus Polybutadien, Polychloropren und Polyisopren ausgewählt ist.

**Revendications**

**1.** Article comportant une couche comprenant un film d'au moins un polymère complexé avec au moins un composé d'un métal du groupe 1B ou du groupe 8, ladite couche ayant la forme d'une surface catalytiquement inerte qui peut être activée sélectivement, en vue d'un dépôt non-électrolytique, par exposition à de l'énergie rayonnante ou à de la chaleur, caractérisé en ce que ledit polymère et ledit composé se trouvent dans la couche en des quantités telles que le rapport du nombre de moles de motifs de monomère dudit polymère au nombre d'atomes dudit métal vaut au moins 20/1.

**2.** Article conforme à la revendication 1, dans lequel des zones sélectionnées de ladite couche sont activées en vue d'un dépôt non-électrolytique.

**3.** Article conforme à la revendication 1, dans lequel des zones sélectionnées de ladite couche superficielle de polymère portent du métal déposé par voie non-électrolytique.

**4.** Article conforme à l'une des revendications 1 à 3, dans lequel ledit polymère est un polymère vinylique ou un polymère insaturé et ledit métal est du palladium, du platine, de l'iridium, du ruthénium, du rhodium, de l'osmium, de l'or, de l'argent ou un mélange de ces métaux.

**5.** Article conforme à la revendication 4, dans lequel ledit métal est du palladium.

**6.** Article conforme à l'une des revendications 1 à 5, dans lequel la concentration de palladium dans les zones de ladite couche qui ne sont pas activées en vue d'un dépôt non-électrolytique vaut moins de 0,1 % en atomes de palladium à la surface du film.

**7.** Article conforme à la revendication 6, dans lequel les zones de ladite couche qui sont catalytiquement inertes peuvent être activées, en vue d'un dépôt non-électrolytique, par exposition pendant jusqu'à 24 heures à un rayonnement UV, à la dose d'environ 7,5 mW/cm$^2$, ce rayonnement, d'une longueur d'onde de 254 nm, provenant d'une lampe à arc à mercure placée à environ 25 mm de ladite surface de film, ou bien par exposition à la chaleur dans un four à 180°C pendant 5 minutes.

**8.** Article conforme à la revendication 3, dans lequel ledit métal déposé par voie non-électrolytique est du cuivre dont les grains ont une taille valant jusqu'à environ 250 nm.

**9.** Article conforme à la revendication 3, dans lequel ledit cuivre déposé par voie non-électrolytique résiste à l'oxydation, reste brillant, sans se ternir, pendant un laps de temps pouvant aller jusqu'a environ 4 mois, et possède une surface pratiquement lisse et pratiquement exempte de pores dont le volume serait supérieur à celui d'un cube de 250 nm de côté.

**10.** Solution de formation de film, comprenant au moins un polymère et au moins un composé d'un métal du groupe IB ou du groupe 8, ladite solution étant adaptée pour fournir des films catalytiquement inertes qui peuvent être sélectivement activés, pour catalyser le dépôt non-électrolytique d'un métal, sous l'action d'une énergie rayonnante ou de la chaleur, caractérisée en ce que le polymère et le composé sont présents en des quantités telles que le rapport du nombre de moles de motifs monomères dudit polymère au nombre d'atomes dudit métal vaut au moins 20/1.

**11.** Solution conforme à la revendication 10, dans laquelle ledit polymère est un polymère vinylique ou un polymère insaturé et ledit métal est du palladium, du platine, de l'iridium, du ruthénium, du rhodium, de l'osmium, de l'or, de l'argent ou un mélange de ces métaux.

**12.** Solution conforme à la revendication 11, dans laquelle ledit polymère est choisi dans le groupe constitué par le polybutadiène, le polychloroprène et le polyisoprène.

22

FIG. I

FIG.2

EP 0 271 466 B1

FIG. 3

FIG. 4

FIG. 5

FIG.6

FIG. 7

FIG. 8